# EUROPÄISCHE PATENTSCHRIFT

(11) **EP 0 668 369 B1**
(45) Veröffentlichungstag und Bekanntmachung des Hinweises auf die Patenterteilung: **03.11.1999**
(21) Anmeldenummer: 95102352.2
(22) Anmeldetag: 20.02.1995
(51) Int. Cl.: C23C 14/32, C23C 14/35

(54) **PVD-Verfahren zur Abscheidung von mehrkomponentigen Hartstoffschichten**
PVD process for the deposition of multi-component hard material layers
Procédé PVD de dépôt des couches en matériaux durs ayant plusieurs composants

(30) Priorität: 21.02.1994 DE 4405477
(43) Veröffentlichungstag der Anmeldung: 23.08.1995
(73) Patentinhaber: HAUZER HOLDING B.V., NL-5900 AE Venlo (NL)
(72) Erfinder: Münz, Wolf-Dieter, Dr., Sheffield, South Yorkshire S7 1SL (GB); Trinh, Thuan-Thon, Dipl.-Ing., D-52074 Aachen (DE); Hurkmans, Antonius Petrus Arnoldus, Ir., NL-5862 AE Geijsteren (NL)
(74) Vertreter: Manitz, Finsterwald & Partner

(56) Entgegenhaltungen:
- EP-A- 0 439 561

## Beschreibung

Hartstoffbeschichtungen zählen heute zu den eingeführten industriellen Verfahren der Oberflächentechnik. Hartstoffschichten werden in CVD (Chemical Vapour Deposition) bzw. in PVD (Physical Vapour Deposition) hergestellt und umfassen im wesentlichen die Nitride, Karbide, Karbonitride und Oxide der Metalle Ti, Zr, Al, Hf, Mo, V oder W bzw. binäre und ternäre Verbindungen aus dieser Reihe.

Insbesondere bei den mehrkomponentigen Materialien hat sich die PVD-Technik als Abscheideverfahren durchgesetzt. Auf diesem speziellen Bereich wiederum ist das Verfahren der reaktiven Verdampfung in einer elektrischen Bogenentladung bzw. die reaktive Kathodenzerstäubung mit dem unbalanzierten Magnetron /1/ besonders erfolgreich hervorgetreten. TiAlN gehört zum Beispiel zu jenen Beschichtungsmaterialien, die mit Hilfe beider Verfahren auf Werkzeuge aus Schnellarbeitsstahl bzw. Hartmetall abgeschieden werden /2/3/. Der Zusatz von Al zum herkömmlich bekannten TiN erhöht die Oxidations/4/ und die Abrasivbeständigkeit /5/ der Beschichtung beträchtlich, so daß es zu einer wesentlichen Verbesserung der damit beschichteten Werkzeuge kommt, wenn man sie bei hohen Schneidgeschwindigkeiten oder in hochkohlenstoffhaltigen Materialien wie Kaltarbeitsstahl oder Grauguß einsetzt /2/.

Die Spezialisierung von Beschichtungen auf bestimmte Anwendungen hin geht weiter. Neue Materialien werden entwickelt oder bestehende Verfahren werden miteinander kombiniert. Zu den letztgenannten Möglichkeiten zählt das sogenannte ABS™-Verfahren, bei dem die Vorteile des kathodischen Bogenverdampfungsverfahrens mit denen der Kathodenzerstäubung mit dem unbalanzierten Magnetron miteinander verbunden werden (EPA 439 561).

Dabei wird mit hochionisiertem Dampf der kathodischen Bogenverdampfung der Ätzprozeß der zu beschichtenden Substrate als Vorbehandlung zur eigentlichen Beschichtung mit dem unbalanzierten Magnetron ausgeführt. Auf diese Weise wird nicht nur das zu beschichtende Substrat in vacuo gereinigt, sondern es wird auch durch Ionenimplantation und Diffusion der Metallkomponente der Beschichtungsmaterialen ins Substrat eine "Verankerungszone" im allernächsten Bereich zur Substratoberfläche gebildet /6/, die zu einer wesentlichen Steigerung der Haftfestigkeit zwischen Haftstoffbeschichtung und Substrat führt /7/.

Es ist auch bekannt, die Schichtbildung selbst gleichzeitig mit kathodischer Bogenentladung /8/9/ oder anodischer Bogenentladung /8/ durchzuführen. Entweder man kann hiermit die Nachteile des balanzierten Magnetrons hinsichtlich Schichtdicke und Schichtfestigkeit kompensieren und dichte verbesserte Schichten herstellen /8/, oder man kann das kolummare Mikrogefüge von Hartstoffschichten verfeinern und "glasige" Schichten mit extrem glatter Schichtoberfläche entwickeln. Dies ist insbesondere der Fall, wenn man zum Beispiel Ta in TiN einbaut /9/. Dabei wurde in letztgenannter Arbeit TiN mit dem kathodischen Bogenverdampfer abgeschieden und Ta mit dem unbalanzierten Magnetron.

Die vorliegende Erfindung basiert auf einer Kombinationsbeschichtung mit dem unbalanzierten Magnetron und dem kathodischen Bogenverdampfungsverfahren nach den Patentansprüchen 1 bis 7.

Im Gegensatz zu dem bisher bekannten Verfahren /8/ wird das kathodische Bogenverfahren gezielt benutzt, um metallische Elemente in das Schichtgefüge einzubauen, die sich in der hochionisierten Bogenentladung durch überdurchschnittlich hohe Mehrfachionisation auszeichnen.

So geht aus der Tabelle 1 hervor, daß zum Beispiel die Übergangselemente Nb, Mo, Hf und Ta bis fünf Elektronen im Bogenentladungsplasma abgeben. Beim Element W wurde sogar eine sechsfache Ionisation gefunden /10/. Im Mittel ergibt sich aus diesen Zahlen für die genannten Elemente ein Ionisierungskoeffizient von circa 3. Aufgrund dieses hohen Ionisationsgrades wird auch die Energie der bei der Kondensation auftreffenden Metallionen unter dem Einfluß einer negativen Biasspannung selektiv mehr erhöht als jene des ebenfalls am Schichtbildungsprozeß eingreifenden, einfach ionisierten Ar+-Ions oder jene der im anodischen Bogenentladungsplasma oder im unbalanzierten Magnetronplasma ebenfalls nur einfach ionisierten Metallionen. Die Mehrfachionisation ist in der PVD-Technik ein typisches Merkmal allein der kathodischen Bogenentladung.

Es hat sich gezeigt, daß allein der Einbau von zum Beispiel nur wenigen at% Nb in eine mit dem unbalanzierten Magnetron abgeschiendene Ti_{0.5}Al_{0.5}N-Schicht die ursprünglich erzielte Härte der Schicht auf Hartmetall-Substraten von HV 2300 auf HV 2800 ansteigt. Parallel dazu wurde aber auch gefunden, daß die Eigenspannungen in der Schicht von 0,5 GPa/µm auf 1,2 GPa/µm ansteigen. Dieser Anstieg der Eigenspannung ist jedoch auch verbunden mit einer Reduzierung der mittels kritischer Last ermittelten Haftfestigkeit der Schicht auf dem Substrat von circa 100 N auf nur 60 N. Dieser Wert stellt bereits einen sehr niedrigen Grenzwert dar, der für Werkzeuge bei Fräsanwendungen zulässig ist.

Um den positiven Einfluß des Kombinationsverfahrens möglichst nachteilsfrei ausnutzen zu können, wird erfindungsgemäß die Schichtbildung nur mit dem unbalanzierten Magnetron gestartet. Entweder man startet die Beschichtung mit dem Grundmaterial der Schicht im unbalanzierten Magnetronmodus alleine, zum Beispiel TiN oder TiAlN, und schaltet die kathodische Bogenentladung mit dem mehrfachionisierten zusätzlichen Einbaumaterial, zum Beispiel Nb oder Ta oder W, erst im späteren Verlauf der Schichtabscheidung dazu, oder man scheidet das Einbaumaterial gemeinsam mit dem Grundmaterial zunächst mit dem unbalanzierten Magnetron ab und schaltet auch in diesem Fall erst im späteren Verlauf der Beschichtung für das Einbaumaterial auf die kathodische Bogenentladung um.

Dazu ist es sehr vorteilhaft, eine Mehrzweckkathodenanordnung für kathodische Bogenentladung (KBE) bzw. unbalanzierte Magnetronzerstäubung (UBM) zu verwenden, wie sie in /11/ beschrieben wurde.

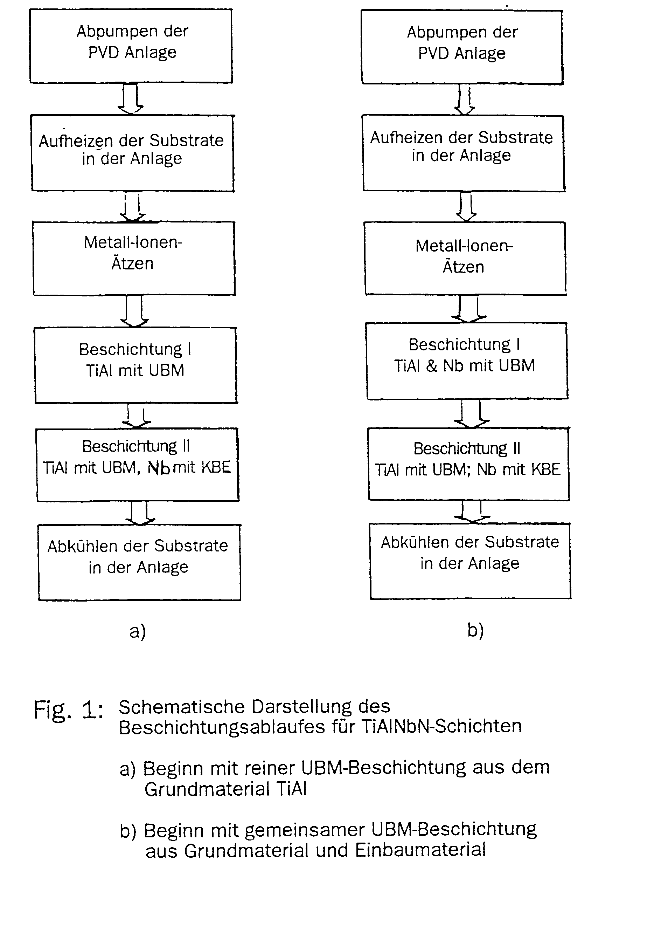

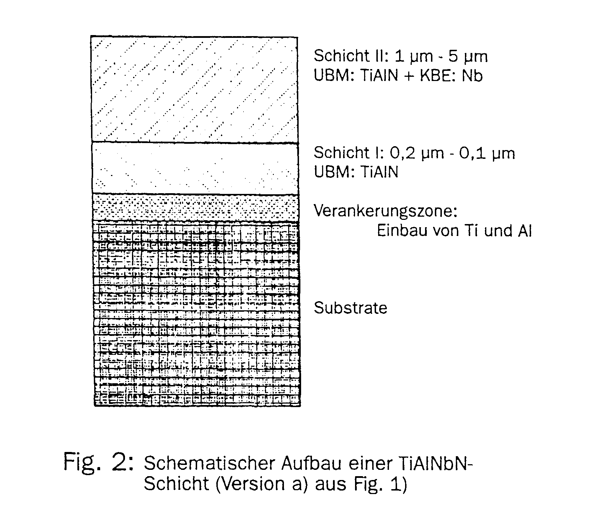

Figur 1 a und 1 b beschreiben den typischen Beschichtungsablauf für den Fall der Mehrkomponenten-Hartstoffschicht TiAlNb N in ABS™-Technik (EPA 439 561).

Erfindungsgemäß ergibt sich dann ein Schichtaufbau wie er in Figur 1 in der Schichtfolge der Version von Figur 1 a schematisch dargestellt ist.

In Figur 2 ist auch die "Verankerungszone" dargestellt. Dies ist jener Bereich des Substrates, in dem Metallatome aus dem während des Ätzprozesses hergestellten Metalldampf der kathodischen Bogenentladung durch Ionenimplantation und Diffusion eingebaut werden.

Es hat sich gezeigt, daß zu diesem Zwecke auch das refraktäre Element Nb, aber auch Ti bzw. eine Legierung aus TiNb, vorteilhaft als Targetmaterial der KBE benutzt werden kann. Dazu wird die in /12/ beschriebene Dropletbildung während der kathodischen Bogenentladung des ABS™-Prozesses auf pulvermetallurgisch hergestellten Ti_{0.5}Al_{0.5}-Targets aufgrund der Eliminierung des niedrig schmelzenden Aluminium aus dem Bogenentladungsprozeß deutlich reduziert. Eine ebenso deutliche Reduzierung von Schichtwachstumsdefekten, die sich auf den Dorplets in der anschließenden Beschichtung mit dem unbalanzierten Magnetron entwickeln, ist die Folge.

Besonders vorteilhaft ist es dann, wenn man für den kathodischen Bogenentladungsprozeß mit einer Legierung startet aus mehrheitlich Ti, zum Beispiel 70 at% Ti und 30 at% Nb, und dieses Target auch während der Beschichtung mit dem UBM benützt.

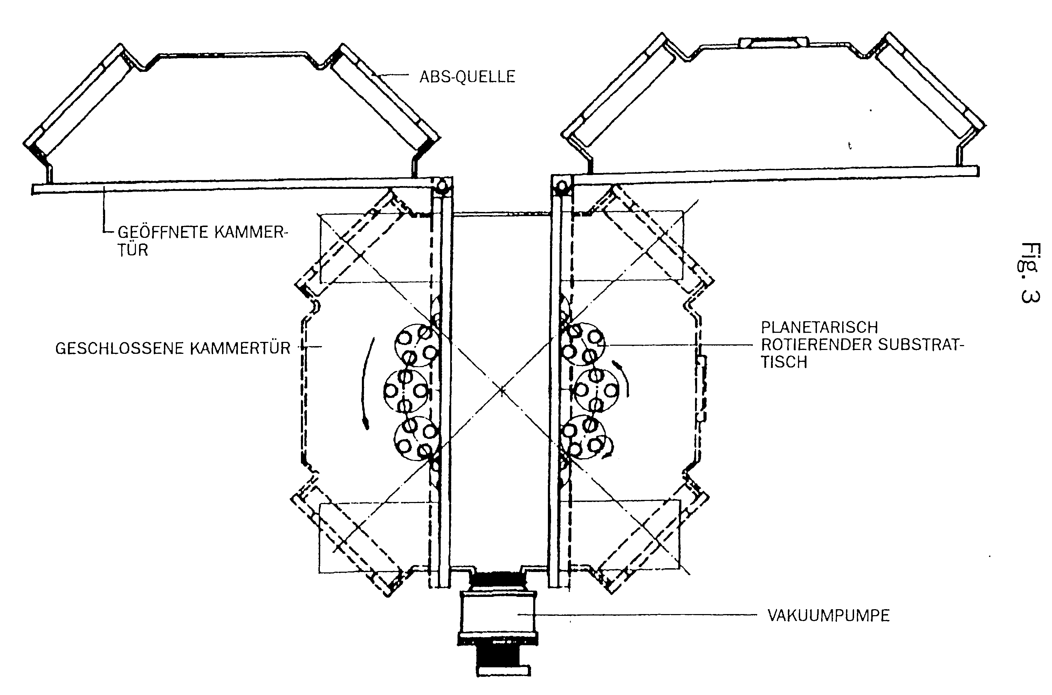

Figur 3 zeigt den Querschnitt einer Beschichtungsanlage, die mit vier vertikal angeordneten Kathoden ausgestattet ist, die wahlweise im KBE- oder UBM-Modus gefahren werden können /11/.

Tabelle 2 gibt eine Übersicht über typische Beschichtungsparameterbereiche für TiAlNbN, wie sie in einer derartigen Anlage angewandt werden können, sowie ein im Detail spezifiziertes Beschichtungsbeispiel wieder. Alle Beschichtungen können entweder auf Substraten aus Schnellarbeitsstahl HSS oder Hartmetall abgeschieden werden.
/1/ W.-D. Münz
   Surf Coat Technol. 48 (1991) 81
/2/ W.-D. Münz
   J. Vac. sci. Technol. A, 4 (6) (1986) 2117
/3/ J.R. Roos, J.P. Celis, E. Vancoille, H. Veltrop, S. Boelens, F. Jungblut, J. Ebberink, H. Homberg
   Thin Solid Films, 193/194 (1990) 547
/4/ D. NcIntyre, J.E. Greene, G. Häkansson, J.-E. Sundgreen, W.-D. Münz, J. Appl. Phys. 67 (1990) 1542
/5/ H. Dimigen, H. Hübsch, V. Schaal
   Proc. SURTEC,, Berlin 89, ed. H. Czichos, L.G.E. Vollrath Carl Hanser, München (1989), 159
/6/ G. Häkansson, L. Hultmann, J.-E. Sundgreen, J.E. Greene, W.-D.Münz Surf. Coat. Technol. 48 (1991) 51
/7/ W.-D. Münz, T. Hurkmans, T. Trinh
   J. Vac. Sci. Technol. A, 11 (5) Sept./Oct. (1993) 2583
/8/ E. Bergmann, Europäische Patentschrift
   Veroff. Nr. 0306612B1, Anmeldetag 23.8.88
/9/ H. Freller, H.-P. Lorenz, P. Schrade
   Surf. Coat. Technol., 54/55 (1992) 148
/10/ I.G.Brown, X.Godechot
   IEEE Trans on Plasma Science, 19 (5) Oct. (1991) 713
/11/ W.-D. Münz, F.J.M.Hauzer, D.Schülze
   Surf. Coat. Technol. 50(1992) 169
/12/ W.-D. Münz, D.B.Lewis, S.Creaney, T.Hurkmans, T. Trinh, W.y. IJzendoorn
   Vacuum, in press

**TABELLE 1**

| Element | Z | Q=+1 | +2 | +3 | +4 | +5 | +6 | Q_{average} |
|---|---|---|---|---|---|---|---|---|
| Li | 3 | 100 | | | | | | 1.0 |
| C | 6 | 100 | | | | | | 1.0 |
| Mg | 12 | 46 | 54 | | | | | 1.5 |
| Al | 13 | 38 | 51 | 11 | | | | 1.7 |
| Si | 14 | 63 | 35 | 2 | | | | 1.4 |
| Ca | 20 | 8 | 91 | 1 | | | | 1.9 |
| Sc | 21 | 27 | 67 | 6 | | | | 1.8 |
| Ti | 22 | 11 | 75 | 14 | | | | 2.1 |
| V | 23 | 8 | 71 | 20 | 1 | | | 2.1 |
| Cr | 24 | 10 | 68 | 21 | 1 | | | 2.1 |
| Mn | 25 | 49 | 50 | 1 | | | | 1.5 |
| Fe | 26 | 25 | 68 | 7 | | | | 1.8 |
| Co | 27 | 34 | 59 | 7 | | | | 1.7 |
| Ni | 28 | 30 | 64 | 6 | | | | 1.8 |
| Cu | 29 | 16 | 63 | 20 | 1 | | | 2.0 |
| Zn | 30 | 80 | 20 | | | | | 1.2 |
| Y | 39 | 5 | 62 | 33 | | | | 2.3 |
| Zr | 40 | 1 | 47 | 45 | 7 | | | 2.6 |
| Nb | 41 | 1 | 24 | 51 | 22 | 2 | | 3.0 |
| Mo | 42 | 2 | 21 | 49 | 25 | 3 | | 3.1 |
| Pd | 46 | 23 | 67 | 9 | 1 | | | 1.9 |
| Ag | 47 | 13 | 61 | 25 | 1 | | | 2.1 |
| Cd | 48 | 68 | 32 | | | | | 1.3 |
| In | 49 | 66 | 34 | | | | | 1.4 |
| Sn | 50 | 47 | 53 | | | | | 1.5 |
| Ba | 56 | | 100 | | | | | 2.0 |
| La | 57 | 1 | 76 | 23 | | | | 2.2 |
| Ce | 58 | 3 | 83 | 14 | | | | 2.1 |
| Pr | 59 | 3 | 69 | 28 | | | | 2.2 |
| Nd | 60 | | 83 | 17 | | | | 2.2 |
| Sm | 62 | 2 | 83 | 15 | | | | 2.1 |
| Gd | 64 | 2 | 76 | 22 | | | | 2.2 |
| Dy | 66 | 2 | 66 | 32 | | | | 2.3 |
| Ho | 67 | 2 | 66 | 32 | | | | 2.3 |
| Er | 68 | 1 | 63 | 35 | 1 | | | 2.4 |
| Yb | 70 | 3 | 88 | 8 | | | | 2.1 |
| Hf | 72 | 3 | 24 | 51 | 21 | 1 | | 2.9 |
| Ta | 73 | 2 | 33 | 38 | 24 | 3 | | 2.9 |
| W | 74 | 2 | 23 | 43 | 26 | 5 | 1 | 3.1 |
| Ir | 77 | 5 | 37 | 46 | 11 | 1 | | 2.7 |
| Pt | 78 | 12 | 69 | 18 | 1 | | | 2.1 |
| Au | 79 | 14 | 75 | 11 | | | | 2.0 |
| Pb | 82 | 36 | 64 | | | | | 1.6 |
| Bi | 83 | 83 | 17 | | | | | 1.2 |
| Th | 90 | | 24 | 64 | 12 | | | 2.9 |
| Ge | 32 | 60 | 40 | | | | | 1.4 |
| Sr | 38 | 2 | 98 | | | | | 2.0 |
| U | 92 | | 12 | 58 | 30 | | | 3.2 |

**Tabelle 2:**

| Parameter für die Herslellung von TiAlNbN aut HSS und Hartmetall In der Beschichtungsanlage nach Fig. 3 | | | |
|---|---|---|---|
| **Prozeßschritte** | **Einheit** | **Parameterbereiche** | **Detailliertes Anwendungsbeispiel** |
| Aufheizen der Substrate : | | | |
| Temperatur | °C | 100-450 | 300 |

| Metail-Ionen-Ätzen : | | | |
|---|---|---|---|
| Targetmaterial TiAl | at % | 50 Ti 50 Al | ---- |
| TiNb | at % | 10 - 50 Nb | 75 Ti 25 Nb |
| | | | |
| Druck (Argon) | mbar | 0-5. 10-3 | 0,5. 10-3 |
| | | | |
| Strom KBE | A | 50 - 200 | 75 |
| | | | |
| Biasspannung UE | V | -1000 bis -1500 | - 1200 |
| | | | |
| Temperatur ϑE | °C | < 450 | 354 - 450 |
| | | | |
| Dauer tE | min | 1 - 10 | 4 |

| Beschichtung I (UBM): | | | |
|---|---|---|---|
| Druck p total ( pAr + pN2 ) | mbar | (2 - 10). 10-3 | 3,5.10-3 |
| | | | |
| Druct p Argon | mbar | (1,8 - 9,5 ).10-3 | 3,25. 10-3 |
| | | | |
| Leistung pro UBM-Kathode | kW | 5-12 | 7 |
| | | | |
| Biasspannung UB I | V | -30 bis -150 | -75 |
| | | | |
| Biasstromdichte jB I | mA/cm² | 2 - 5 | 3 |
| | | | |
| Temperatur ϑSp I | °C | 350 - 500 | 450 ± 20 |
| | | | |
| Schichtdicke dSp I | µm | 0,1 - 1,0 | 0,75 ± 0,25 |

| Beschichtung II (UBM + KBE ): | | | |
|---|---|---|---|
| Druck p total ( pAr + pN2 ) | mbar | (2 - 10). 10-3 | 3,5. 10-3 |
| | | | |
| Druck p Argon | mbar | (1,8 - 9,5).10-3 | 3,25.10-3 |
| | | | |
| Leistung pro UBM-Kathode | kW | 5-12 | 7 |
| | | | |
| Strom KBE-Kathode | A | 50 - 200 | 75 |
| | | | |
| Biasspannung UB II | V | -30 bis -150 | -75 |
| | | | |
| Blasstromdichte j B II | mA.cm² | 2 - 5 | 3 |
| | | | |
| Temperatur ϑSp II | °C | 350 - 500 | 450 ± 20 |
| | | | |
| Schichtdicke dSp II | µm | 0,5 - 5,0 | 2,25 ± 0,5 |

| Abkühlung der Substrate: | | | |
|---|---|---|---|
| Temperatur | °C | 150 - 350 | 250 |

## Patentansprüche

1. PVD-Beschichtungsverfahren, bei dem Hartstoffschichten, bestehend aus Nitriden oder Karbonitriden der Metalle Ti, Zr, Hf oder aus Legierungen von TiAl, ZrAl, HfAl, TiZr, TiZrAl mit einem unbalanzierten Magnetron hergestellt werden,
dadurch **gekennzeichnet,**
daß der Beschichtungsprozeß allein mit dem unbalanzierten Magnetron begonnen und mit der Kombination aus dem unbalanzierten Magnetron und einem kathodischen Bogenentladungsverdampfer fortgesetzt wird und
daß während einer bestimmten Zeitspanne des mit dem unbalanzierten Magnetron ausgeführten Beschichtungsprozesses zusätzliches Beschichtungsmaterial aus den Elementen Nb, Mo, Ta, W oder aus einer Legierung dieser Elemente aus einer kathodischen Bogenentladungsverdampfung auf die zu beschichtenden Substrate abgeschieden und in das Schichtgefüge eingebaut wird.

2. PVD-Beschichtungsverfahren nach Anspruch 1,
dadurch **gekennzeichnet,**
daß das zusätzliche Beschichtungsmaterial, das mit einem kathodischen Bogenentladungsverdampfer abgeschieden wird, aus einer Legierung aus den Elementen Nb, Mo, Ta, W mit den Metallen Ti, Zr, Hf oder aus Legierungen von TiAl, ZrAl, HfAI, TiZr oder TiZrAl besteht.

3. PVD-Beschichtungsverfahren nach Anspruch 1,
dadurch **gekennzeichnet,**
daß die Schichtdicke des ersten Teils der Beschichtung mit dem unbalanzierten Magnetron zwischen 0,1 µm bis 1 µm beträgt und daß die Schichtdicke des Materials gleichzeitig hergestellt mit dem unbalanzierten Magnetron und dem kathodischen Bogenentladungsverdampfer zwischen 0,5 µm bis 5 µm beträgt.

4. PVD-Beschichtungsverfahren nach Anspruch 1,
dadurch **gekennzeichnet,**
daß der Beschichtungsanteil aus dem kathodischen Bogenentladungsverdampfer zwischen 0,5 % und 50 % Volumenanteilen liegt.

5. PVD-Beschichtungsverfahren nach Anspruch 1 und 2,
dadurch **gekennzeichnet,**
daß bei TiAlN-Basis-Schichten ein Metallionen-Ätzen vor der Beschichtung im Dampf der kathodischen Bogenentladung mit Targets durchgeführt wird, die kein Al enthalten.

6. PVD-Beschichtungsverfahren nach Anspruch 5,
dadurch **gekennzeichnet,**
daß für die kathodische Bogenentladung ein Target aus der Legierung TiNb verwendet wird.

7. PVD-Beschichtungsverfahren nach Anspruch 6,
dadurch **gekennzeichnet,**
daß der Anteil Nb im TiNb-Target zwischen 5 at% und 30 at% beträgt.

## Claims

1. PVD coating process in which hard material layers consisting of nitrides or carbonitrides of the metals Ti, Zr, Hf or of alloys of TiAl, ZrAl, HfAl, TiZr, TiZrAl are produced with an imbalanced magnetron, characterized in that the coating process is started only with the imbalanced magnetron and continued with the combination of the imbalanced magnetron and a cathodic arc discharge vaporiser; and in that during a specific time interval of the coating process carried out with the imbalanced magnetron, additional coating material from the elements Nb, Mo, Ta, W or from an alloy of these elements is deposited from a cathodic arc discharge vaporisation process onto the substrates to be coated and incorporated into the layer structure.

2. PVD coating process in accordance with claim 1, characterized in that additional coating material which is deposited with a cathodic arc discharge vaporiser consists of an alloy of the elements Nb, Mo, Ta, W with the metals Ti, Zr, Hf or of alloys of TiAl, ZrAl, HfAl, TiZr or TiZrAl.

3. PVD coating process in accordance with claim 1, characterized in that the layer thickness of the first part of the coating with the imbalanced magnetron amounts to between 0.1 µm to 1 µm, and in that the layer thickness of the material simultaneously produced with the imbalanced magnetron and the cathodic arc discharge vaporiser amounts to between 0.5 µm to 5 µm.

4. PVD coating process in accordance with claim 1, characterized in that the proportion of the coating from the cathodic arc discharge vaporiser amounts to between 0.5 % and 50 % by volume.

5. PVD coating process in accordance with claim 1 and 2, characterized in that with TiAlN base layers a metal ion etching is carried out prior to the coating in the vapour of the cathodic arc discharge with targets which do not contain Al.

6. PVD coating process in accordance with claim 5, characterized in that a target of the alloy TiNb is used for the cathodic arc discharge.

7. PVD coating process in accordance with claim 6, characterized in that the proportion of Nb in the TiNb target amounts to between 5 at% and 30 at%.

## Revendications

1. Procédé de revêtement par dépôt physique en phase vapeur (DPV) dans lequel on prépare des couches de matériau dur, formées de nitrures ou de carbonitrures des métaux Ti, Zr, Hf ou d'alliages de TiAl, ZrAl, HfAl, TiZr, TiZrAl avec un magnétron non équilibré, caractérisé en ce que ledit procédé de revêtement commence seulement avec le magnétron non équilibré et se poursuit avec la combinaison du magnétron non équilibré et d'un vaporisateur à décharge en arc à la cathode et en ce que, pendant un laps de temps défini du procédé de revêtement effectué avec le magnétron non équilibré, un matériau supplémentaire de revêtement choisi parmi les éléments Nb, Mo, Ta, W ou un alliage de ces éléments est déposé, à partir d'une vaporisation par décharge en arc à la cathode, sur les substrats à revêtir et incorporé dans la structure stratifiée.

2. Procédé de revêtement DPV selon la revendication 1, caractérisé en ce que le matériau supplémentaire de revêtement qui est déposé avec un vaporisateur à décharge en arc à la cathode est constitué d'un alliage des éléments Nb, Mo, Ta, W avec les métaux Ti, Zr, Hf ou d'alliages de TiAl, ZrAl, HfAl, TiZr ou TiZrAl.

3. Procédé de revêtement DPV selon la revendication 1, caractérisé en ce que l'épaisseur de la couche de la première partie du revêtement effectué avec le magnétron non équilibré est comprise entre 0,1 µm et 1 µm et en ce que l'épaisseur de la couche du matériau produit simultanément avec le magnétron non équilibré et le vaporisateur à décharge en arc à la cathode est comprise entre 0,5 µm et 5 µm.

4. Procédé de revêtement DPV selon la revendication 1, caractérisé en ce que la proportion de revêtement provenant du vaporisateur à décharge en arc à la cathode est comprise entre 0,5 % et 50 % en volume.

5. Procédé de revêtement DPV selon les revendications 1 et 2, caractérisé en ce que pour des couches à base de TiAlN, on effectue une attaque par ions métalliques avant le revêtement dans la vapeur de la décharge en arc à la cathode avec des cibles qui ne contiennent pas de Al.

6. Procédé de revêtement DPV selon la revendication 5, caractérisé en ce qu'on utilise une cible formée de l'alliage TiNb pour la décharge en arc à la cathode.

7. Procédé de revêtement DPV selon la revendication 6, caractérisé en ce que la proportion de Nb dans la cible de TiNb est comprise entre 5 % atm. et 30 % atm.
